# EUROPÄISCHE PATENTSCHRIFT

(11) **EP 2 356 265 B1**
(45) Veröffentlichungstag und Bekanntmachung des Hinweises auf die Patenterteilung: **05.03.2014**
(21) Anmeldenummer: 09778893.9
(22) Anmeldetag: 05.11.2009
(51) Int. Cl.: C23C 14/54

(54) **TESTGLASWECHSELSYSTEM.**
TEST GLASS CHANGING SYSTEM
SYSTÈME DE REMPLACEMENT DE VERRE DE TEST

(30) Priorität: 06.11.2008 DE 102008056125
(43) Veröffentlichungstag der Anmeldung: 17.08.2011
(73) Patentinhaber: Leybold Optics GmbH, 63755 Alzenau (DE)
(72) Erfinder: SCHERER, Michael, 63796 Kahl (DE)
(74) Vertreter: Pohlmann, Bernd Michael
(86) Internationale Anmeldenummer: PCT/EP2009/007938
(87) Internationale Veröffentlichungsnummer: WO 2010/052000

(56) Entgegenhaltungen:
- DE-A1- 3 604 624
- HERRMANN R ET AL: "Automated control of optical layer fabrication processes" PROCEEDINGS OF THE SPIE - THE INTERNATIONAL SOCIETY FOR OPTICAL ENGINEERING, SPIE, US, Bd. 401, 20. April 1983 (1983-04-20), Seiten 83-92, XP008118251 ISSN: 0277-786X

## Beschreibung

Die Erfindung betrifft ein Testglaswechselsystem zur selektiven Beschichtung und optischen Messung einer Testglasplatte in einer Vakuum-Beschichtungsanlage, wie es beispielsweise in der gattungsbildenden DE 36 04 624 A1 beschrieben ist.

Die Herstellung optischer Vielfach-Schichtsysteme, die auch als Interferenz-Schichten bezeichnet werden, spielt beispielsweise in optischen Erzeugnissen wie Bandpassfiltern, Kantenfiltern, Kaltlichtspiegeln, Strahlteilern und Antireflexschichten eine bedeutende Rolle. Ziel einer solchen Beschichtung ist es, innerhalb eines vorgegebenen Wellenlängenbereichs eine möglichst vollständige Transmission oder Reflexion an dem Vielfach-Schichtsystem zu erreichen, in den außerhalb liegenden Wellenlängenbereichen jedoch möglichst übergangslos eine vernachlässigbare Transmission bzw. Reflexion zu erzielen. Die Erfüllung dieser Forderung setzt eine große Zahl von Einzelschichten voraus, wobei beispielsweise abwechselnd eine hochbrechende und eine niedrigbrechende Schicht auf das Substrat aufgetragen werden; es können auch zwei hochbrechende oder zwei niedrigbrechende Schichten unmittelbar aufeinanderfolgen.

Bei der Herstellung solch komplexer Schichtsysteme, insbesondere bei der Herstellung von Multischichten mit speziellen Funktionseigenschaften, ist eine regelmäßige Messung bzw. Prüfung der auf die Substrate aufgebrachten Funktionsschichten notwendig, um die gewünschten Schichtdicken und Schichteigenschaften zu gewährleisten. Hierzu werden Testgläser eingesetzt, auf denen jeweils eine einzelne Schicht abgeschieden und geprüft wird. Bei komplexen optischen Filtern sind zum Erreichen der Filterspezifikationen mehrere Testglaswechsel notwendig. Für die geforderte Genauigkeit muss das Testglas am Ort der Substrate angeordnet sein und im Wesentlichen die gleiche Beschichtung wie das Substrat erfahren; weiterhin sollte der Testglaswechsel zwischen den einzelnen Beschichtungssequenzen möglichst automatisiert, d.h. ohne manuellen Austausch der Testgläser durch eine Bedienperson, erfolgen.

Aus der DE 36 04 624 A1 ist ein Testglaswechsler bekannt, der einen Testglaswechsel bei geschlossener Beschichtungskammer gestattet. An einem Drehteller, durch den die Substrate auf einer Bahn durch mindestens einen Strom eines Beschichtungsmaterials geführt werden, ist eine Halterung für die Aufnahme mehrerer Testgläser gelagert. Die Halterung wird mit dem Drehteller bewegt und ist gegenüber dem Drehteller drehbar gelagert. Ein Schrittschaltwerk, das entlang der Bahn des Drehtellers angeordnet ist, schaltet jeweils ein Testglas in eine relativ zum Drehteller stationäre Position, in der es mit den Substraten für eine vorgebbare Anzahl von Umdrehungen des Drehtellers alternierend durch den Strahlengang der Messvorrichtung und durch den Strom des Beschichtungsmaterials geführt wird. Die Halterung ist durch einen Deckel abgedeckt, der stationär auf dem Drehteller befestigt ist und jeweils nur ein einziges Testglas in seiner Beschichtungs- und Messposition freilässt. Die Drehung der Halterung erfolgt durch einen beweglichen, im Inneren der Beschichtungskammer angeordneten Schaltfinger, der in die Umlaufbahn des Drehtellers hineinragt und mit Vorsprüngen auf der Halterung zusammenwirkt. Beim Eingriff des Schaltfingers in einen Vorsprung der Halterung wird ein Testglas aus seiner Kongruenzlage mit dem Messfenster hinausgedreht, und das nachfolgende Testglas rückt an seine Stelle. Der Testglaswechsler der DE 36 04 624 A1 gestattet somit einen Testglaswechsel bei geschlossener Beschichtungskammer. Allerdings ist die Beladung des Testglaswechslers sehr aufwendig, da die einzelnen Testgläser durch die Substratschleuse hindurch in die Halterung des Testglaswechslers eingelegt werden müssen. Weiterhin kann der in der DE 36 04 624 A1 gezeigte Testglaswechsler in nur eine vergleichsweise geringe Zahl von (vier) Testgläsern aufnehmen, so dass bei der Herstellung eines Vielfach-Schichtsysteme (mindestens) ein manueller Austausch der Testgläser notwendig ist.

Der Erfindung liegt daher die Aufgabe zugrunde, den bekannten Stand der Technik in einer solchen Weise weiterzuentwickeln, dass einen größere Zahl von Testgläsern bereitgestellt werden, die ohne manuelles Eingreifen im Inneren der Beschichtungskammer gewechselt werden können. Weiterhin soll das Einbringen der Testgläser in die Beschichtungskammer auf eine möglichst einfache Art und Weise vollzogen werden.

Die Aufgabe wird durch die Merkmale des Anspruchs 1 gelöst. Vorteilhafte Ausgestaltungen sind Gegenstand der Unteransprüche.

Danach umfasst das Testglaswechselsystem einen Testglashalter mit einer Testglasplatte zur Aufnahme eines oder mehrerer Testgläser und einem Deckel, der die Testglasplatte abdeckt und die darin gehaltenen Testgläser vor Beschichtung schützt. Der Deckel ist mit einem Messfenster versehen, das nur einen kleinen Bereich der Testglasplatte zur Beschichtung freigibt. Es können auch mehrere Messfenster und/oder Referenzfenster vorgesehen sein. Mittels einer Drehvorrichtung, die Teil des Testglaswechselsystems bildet, kann die Testglasplatte gegenüber dem Deckel gedreht werden, wodurch unterschiedliche auf der Testglasplatte befestigte Testgläser in den Bereich des Messfensters bewegt werden, in dem sie beschichtet und vermessen werden. Gegenüber der gattungsbildenden DE 36 04 624 A1 unterscheidet sich das erfindungsgemäße Testglaswechselsystem dadurch, dass der Testglashalter (mit der Testglasplatte und dem Deckel) eine abgeschlossene Einheit bildet, die - ebenso wie die zu beschichtenden Substrate - durch die Substratschleuse in die Beschichtungskammer eingeführt und auf dem Drehteller positioniert werden kann. Dies gestattet eine besonders einfache und zeitsparende Beladung des Drehtellers: Anstelle der in der DE 36 04 624 A1 notwendigen Bestückung des (fest mit dem Drehteller verbundenen) Testglaswechselsystems mit Testgläsern, die einzeln durch die Substratschleuse eingebracht und dort auf der Testglasplatte positioniert werden müssen, kann bei Verwendung der erfindungsgemäßen Testglaswechselsystems die Bestückung bzw. die Vorbereitung des Testglashalters außerhalb der Beschichtungskammer und zeitlich unabhängig vom Substratwechsel durchgeführt werden. Das ist ergonomisch vorteilhaft und spart Zeit. Weiterhin kann eine vergleichsweise große Anzahl von Testgläsern auf dem Testglashalter angeordnet sein.

Der Deckel des Testglashalters ist so gestaltet, dass er gegenüber der Testglasplatte gedreht und abgehoben werden kann. Ein Testglaswechsel innerhalb der Beschichtungskammer wird in einer solchen Weise durchgeführt, dass der Deckel des Testglashalters angehoben wird, die Testglasplatte um einen vorgegebenen Winkel gegenüber dem Deckel gedreht und der Deckel anschließend wieder abgelegt wird. Die zum Drehen der Testglasplatte verwendete Drehvorrichtung ist vorzugsweise als eine Hub-/Drehvorrichtung ausgestaltet, mit deren Hilfe Drehungen um eine Achse parallel zur Drehachse des Drehtellers sowie Hubbewegungen in Richtung dieser Achse durchgeführt werden können. Ein Testglaswechsel erfolgt dann in einer solchen Weise, dass die Testglasplatte in Achsrichtung vom Drehteller (bzw. einem auf dem Drehteller ruhenden Grundkörper des Testglashalters) abgehoben wird und der Deckel in Achsrichtung von der Testglasplatte abgehoben wird; diese beiden Hubbewegungen können gleichzeitig oder zeitlich zueinander versetzt durchgeführt werden. Anschließend wird die Testglasplatte gedreht, wodurch der unter dem Messfenster des Deckels gelegene Bereich der Testglasplatte ausgewechselt wird und ein neuer Bereich der Testglasplatte unterhalb des Messfensters des Deckels zu liegen kommt. In dieser neuen Relativwinkellage werden Testglasplatte und Deckel abgelegt. Wird der Testglashalter nun auf dem Drehteller durch die Beschichtungsstation der Beschichtungskammer bewegt, so wird der soeben unter das Messfenster hineingedrehte Bereich der Testglasplatte beschichtet.

Zum Testglaswechsel an kreisförmigen bzw. zylindrischen Testglasplatten weist die Hub- /Drehvorrichtung weist zweckmäßigerweise zwei konzentrische Ringkörper auf, die beide (vorteilhafterweise gemeinsam) höhenverstellbar sind; einer der beiden Ringkörper kann gesteuert gedreht werden. Der drehbare Ringkörper dient zum Anheben und Drehen der Testglasplatte, während der andere Ringkörper zum Anheben des Deckels dient.

Die Hub-/Drehvorrichtung kann ortsfest in der Bearbeitungskammer angeordnet sein und sich beispielsweise im Bereich der Beschichtungsstation befinden. In diesem Fall kann ein Testglaswechsel nur in einer vorgegebenen Drehposition des Drehtellers stattfinden, wenn sich nämlich der Testglashalter exakt oberhalb der Hub-/Drehvorrichtung befindet. Alternativ ist es möglich, die Testglas-Drehvorrichtung auf dem Drehteller (oder auf einer synchron mit dem Drehteller rotierenden Drehbühne) anzuordnen; dies hat den Vorteil, dass der Testglaswechsel ohne Geschwindigkeitsänderung des Drehtellers und an jeder beliebigen Position in der Beschichtungskammer (beispielsweise während des Transports des Testglashalters zwischen Messstation und Beschichtungsstation) stattfinden kann.

In einer ersten Ausgestaltung der Erfindung ist die Testglasplatte ein kreisscheibenförmiges Monitorglas. In dieser Ausgestaltung kann die gesamte Testglasplatte bzw. ein beliebiger ausgewählter Bereich der Testglasplatte als Testglas dienen. Das Monitorglas ist vorteilhafterweise mit einer zentralen Aussparung versehen, durch die während der optischen Messung ein Referenzstrahl geführt werden kann, um eine Drift des Messlichts zu kontrollierten.

In einer zweiten Ausgestaltung der Erfindung ist die Testglasplatte mit einer Vielzahl von Aufnahmebereichen zur Aufnahme individueller Testgläser versehen. Hier wird die Testglasplatte bei einem Testglaswechsel um einen vorgegebenen Winkel gegenüber dem Deckel gedreht, damit das Testglas exakt unterhalb des Messfensters des Deckels zu liegen kommt.

Im Folgenden wird die Erfindung anhand eines in den Figuren dargestellten Ausführungsbeispiels näher erläutert. Dabei zeigen:
- Fig. 1a, 1b: Schnittdarstellungen einer Beschichtungsanlage mit einem Drehteller;
- Fig. 2: eine schematische Aufsicht auf den Drehteller der Fig. 1a und 1b;
- Fig. 3: ein erfindungsgemäßes Testglaswechselsystem mit einem Testglashalter und einer Hub-/Drehvorrichtung in einer ersten Ausgestaltung:
- Fig. 3a: Aufsicht auf den Testglashalter;
- Fig. 3b: Schnittdarstellung des Testglashalters;
- Fig. 3c: Schnittdarstellung der zugehörigen Hub-/Drehvorrichtung;
- Fig. 4: ein erfindungsgemäßes Testglaswechselsystem mit einem Testglashalter und einer Hub-/Drehvorrichtung in einer weiteren Ausgestaltung:
- Fig. 4a: Aufsicht auf den Testglashatter;
- Fig. 4b: Schnittdarstellung des Testglashalters;
- Fig. 4c: Schnittdarstellung der zugehörigen Hub-/Drehvorrichtung;

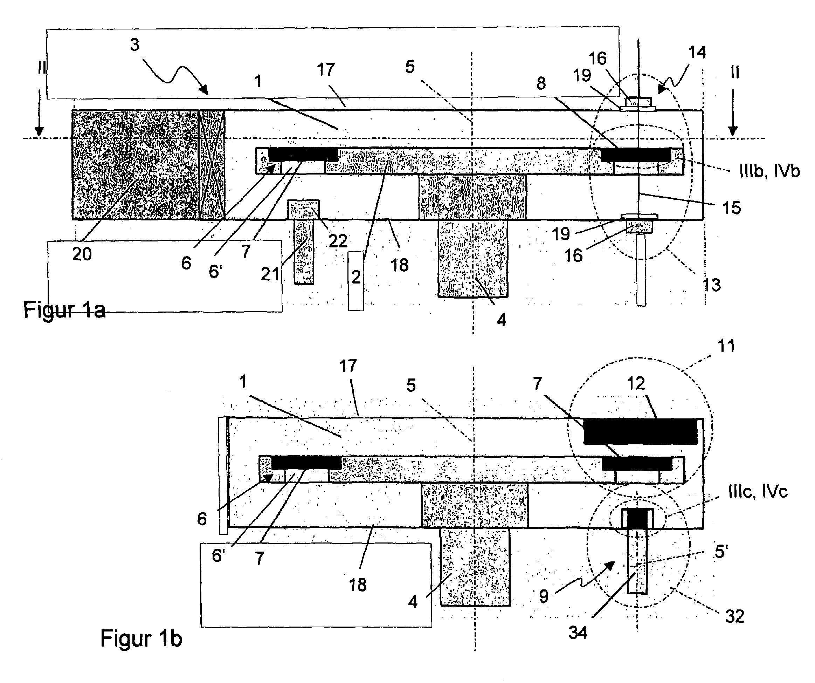

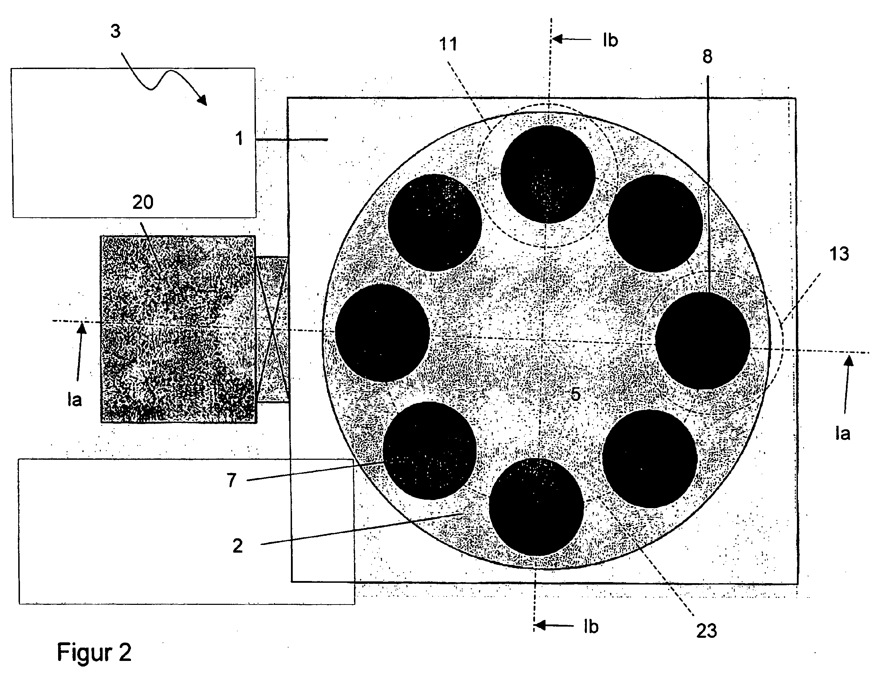

Figur 1a und 1b zeigen schematische Schnittdarstellungen durch eine Beschichtungskammer 1, die Teil einer Vakuum-Beschichtungsanlage 3 bildet. In der Beschichtungskammer 1 befindet sich ein Drehteller 2, der mit Hilfe einer steuer- bzw. regelbaren Dreheinrichtung 4 um eine Drehachse 5 gedreht werden kann. Eine Aufsicht auf den Drehteller 2 ist in Figur 2 dargestellt. Auf dem Drehteller 2 sind mehrere Vertiefungen 6 vorgesehen, die auf einem gemeinsamen Großkreis 23 um die Achse 5 angeordnet sind. Die Vertiefungen 6 können wahlweise mit einem scheibenförmigen Substrat 7 oder mit einem Testglashalter 8 bestückt werden; auf diesen Substraten 7 und auf dem Testglashalter 8 wird in der Beschichtungskammer 1 unter einem Restgas eine Oxidschicht abgeschieden. Der Testglashalter 8 bildet - zusammen mit einer Testglas-Drehvorrichtung 9 - Teil eines Testglaswechselsystems 10.

Die Bestückung des Drehtellers 2 mit Substraten 7 bzw. Testglashalter 8 erfolgt durch eine Substratschleuse 20 in einer Seitenwand der Beschichtungskammer 1. Zur Entnahme der Substrate 7 bzw. Testglashalter 8 ist in der Beschichtungskammer 1 direkt gegenüber der Substratschleuse 20 eine Hubvorrichtung 21 mit einem in Achsrichtung 5 verschiebbaren Stempel 22 angeordnet. Bei einem Substratwechsel wird der Stempel 22 der Hubvorrichtung 21 von unten her durch einen Durchbruch 6' im Vertiefungsbereich 6 des Drehtellers 2 geführt und hebt dabei die im Vertiefungsbereich 6 befindliche Substratscheibe 7 bzw. Testglashalter 8 aus dem Drehteller 2, so dass Substratscheibe 7 bzw. Testglashalter 8 über die Substratschleuse 20 entnommen werden kann. Mittels der Substratschleuse 20 kann leicht ein zweiter usw. Testglashalter 8 ausgetauscht werden und somit auch bei einer sehr großen Anzahl von Schichten genügend Monitorgläser zur Verfügung gestellt werden können ohne das Vakuum zu brechen oder viel Platz für Testglashalter zu verlieren.

Die Beschichtungskammer 1 umfasst eine Beschichtungsstation 11 und eine Messstation 13, die vorzugsweise voneinander durch Blenden abgeteilt und nur durch Schlitze in den Blenden miteinander verbunden sind. In der Beschichtungsstation 11 befindet sich eine Sputtereinrichtung 12, in der - in bekannter Weise - mittels reaktivem Sputtern ein Sputtermaterial eines Targets zerstäubt wird, wobei sich ein Sputtermaterial-Sauerstoff-Verbund an den Wänden der Beschichtungskammer 1 und auf den Substraten 7 bzw. dem Testglashalter 8 niederschlägt. - In der Messstation 13 befindet sich eine optische Messeinrichtung 14, mit der optische Eigenschaften, insbesondere Transmission und/oder Reflexion, der aufwachsenden Schichten bestimmt werden können. Die optische Messeinrichtung 14 umfasst eine oberhalb der Beschichtungskammer 1 angeordnete Messlichtquelle sowie unter- und/oder oberhalb der Beschichtungskammer 1 angeordnete Detektoren 16 zur Messung der transmittierten und/oder reflektierten Strahlung. In der Decke 17 bzw. dem Boden 18 der Beschichtungskammer 1 sind vakuumdicht Fenster 19 eingesetzt, über die der Messlichtstrahl 15 durch die Beschichtungskammer 1 geleitet wird. Die optische Messeinrichtung 14 ist vorzugsweise ein Einwellenlängen- oder Mehrwellenlängen-Spektrometer, insbesondere ein Spektralfotometer oder Spektralellipsometer. Mit Hilfe der optischen Messeinrichtung 14 können werden nach Abscheiden einer vorgegebenen Schichtdicke die optischen Verluste gemessen und eine Einstellung von Schichteigenschaften in Abhängigkeit eines Signals der optischen Messeinrichtung 14 durchgeführt werden. Beim Einsatz eines Spektralfotometers können in einfacher Weise Transmission, Absorption und Reflektion in einem vorgegebenen Spektralbereich und als Funktion der Schichtdicke ermittelt werden.

Neben der in Figur 1 gezeigten Beschichtungsstation 11 können in der Beschichtungskammer 1 noch weitere Bearbeitungsbereiche (z.B. Plasmabearbeitungsbereiche, weitere Sputtereinrichtungen etc.) vorgesehen sein. Weiterhin können weitere Messstationen vorgesehen sein.

Mit Hilfe der Dreheinrichtung 4 wird der Drehteller 2 in der Beschichtungskammer 1 gesteuert bzw. geregelt um die Drehachse 5 gedreht. Dabei werden die Substrate 7 und der Testglashalter 8 auf einer kreisförmigen Bewegungsbahn mindestens einmal nacheinander durch die Beschichtungsstation 11 und die Messstation 13 bewegt. Der Testglashalter 8 weist - wie in Figur 2 angedeutet - näherungsweise den gleichen Durchmesser auf wie die Substratscheiben 7, so dass der Testglashalter 8 - ebenso wie die Substratscheiben 7 - in einer beliebigen Vertiefung 6 des Drehtellers 2 aufgenommen und unter Verwendung der Hubvorrichtung 21 aus dem Drehteller 2 entnommen werden kann.

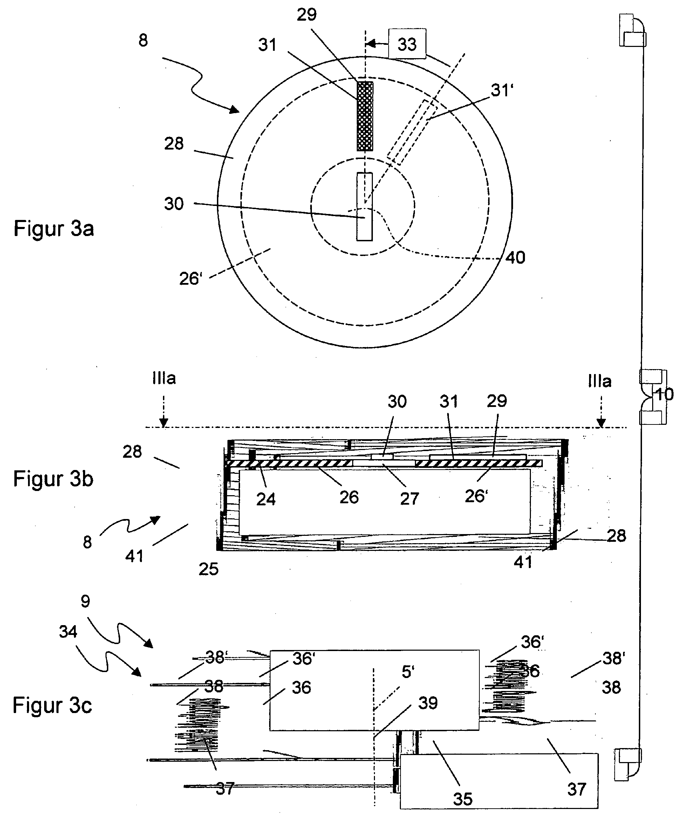

Zur regelmäßigen Überprüfung der auf die Substrate 7 aufgebrachten Beschichtung werden mit Hilfe der Messeinrichtung 13 Messungen an Testgläsern 24 durchgeführt, die im Testglashalter 8 aufgenommen sind. Figuren 3a und 3b zeigen eine Aufsicht (Figur 3a) bzw. eine Schnittdarstellung (Figur 3b) des Testglashalters 8 der Figur 1. Der Testglashalter 8 umfasst einen rohrförmigen Grundkörper 25, auf dem eine kreisscheibenförmige Testglasplatte 26 aufliegt. Die Testglasplatte 26 weist eine zentrale Aussparung 27 auf. Im Ausführungsbeispiel der Figuren 3a und 3b ist die Testglasplatte 26 als Monitorglas 26' ausgeführt, d.h. als durchgängige scheibenförmige Glasplatte mit einer zentralen Aussparung 27. Um eine gezielte Beschichtung ausgewählter Bereiche des Monitorglases 26' zu erreichen, ist das Monitorglas 26' durch einen abnehmbaren kreisförmigen Deckel 28 abgedeckt. Der Deckel 28 ist mit zwei Öffnungen versehen, einem Messfenster 29 und einem Referenzfenster 30. Wird der Testglashalter 8 auf dem Drehteller 2 durch die Beschichtungsstation 11 bewegt, so erfährt der unterhalb des Messfensters 29 liegende Bereich 31 des Monitorglases 26' eine Beschichtung, während die durch den Deckel 28 abgedeckten Restbereiche des Monitorglases 26' unbeschichtet bleiben.

Das Messfenster 29 dient zur optischen Messung der Schichtdicke bzw. Schichteigenschaften des in diesem Fenster 29 liegenden Bereiches 31 des Monitorglases 26' in der Messstation 13. Das mittig auf dem Deckel 28 angeordnete Referenzfenster 30 dient zur 100%-Messung der auf das Monitorglas 26' aufgebrachten Schichten, wodurch eine Drift des Messlichts vermieden wird. Im Ausführungsbeispiel der Figur 3 haben die beiden Fenster 29, 30 eine rechteckige Form; sie können jedoch auch kreisförmig, elliptisch etc. sein. Wird der Testglashalter 8 in die Beschichtungsstation 11 gebracht, so wird der unterhalb des Messfensters 29 liegende Bereich 31 des Monitorglases 26' dem Sputtermedium ausgesetzt und erfährt eine Beschichtung; die Dicke und Zusammensetzung dieser Beschichtung wird in der Messstation 13 ermittelt. In einer Wechselstation 32 wird das im Testglashalter 8 befindliche Monitorglas 26' um einen vorgegebenen Winkel 33 gedreht, um einen weiteren (bisher unbeschichteten) Bereich 31' des Monitorglases 26' unterhalb des Messfensters 29 zu platzieren. Diese Drehung des Monitorglases 26' erfolgt mit Hilfe der in der Wechselstation 32 angeordneten Drehvorrichtung 9, die vorzugsweise als Hub-/Drehvorrichtung 34 ausgestaltet ist und - wie in Figur 1b gezeigt - unterhalb des Drehtellers 2 am Boden 18 der Beschichtungskammer 1 befestigt ist. Im Ausführungsbeispiel der Figur 1b befindet sich die Wechselstation 32 im selben Bereich der Beschichtungskammer 1 wie die Beschichtungsstation 11, so dass die Hub-/Drehvorrichtung 34 unterhalb der Sputtereinrichtung 12 angeordnet ist.

Die Hub-/Drehvorrichtung 34 umfasst zwei konzentrisch angeordnete Ringkörper 35, 37 (siehe Figur 3c) und ist in einer solchen Position in der Beschichtungskammer 1 angeordnet, dass der gemeinsame Mittelpunkt 39 der Ringkörper 35, 37 sich direkt unterhalb des Großkreises 23 der auf dem Drehteller 2 gelagerten Substratscheiben 7 befindet. Der innere Ringkörper 35 kann mit Hilfe einer (in den Figuren nicht dargestellten) Steuerungseinrichtung um eine Achse 5' gedreht werden, die durch seinen Mittelpunkt 39 verläuft und näherungsweise parallel zu Drehachse 5 des Drehtellers 2 ausgerichtet ist. Weiterhin können die Ringkörper 35, 37 mit Hilfe der Steuerungseinrichtung gemeinsam parallel zur Achse 5' verschoben werden. Die Hub- /Drehvorrichtung kann auch in einer solchen Weise gestaltet sein, dass die beiden Ringkörper 35, 37 individuell verschoben werden können, jedoch erfordert dies eine zusätzliche Bewegungsachse; daher ist es vorteilhafter, eine gemeinsame Vorschubbewegung der beiden Ringkörper 35, 37 vorzusehen.

Jeder der Ringkörper 35, 37 ist mit einem Satz von Hubelementen 36, 38, im vorliegenden Ausführungsbeispiel Stiften 36', 38', versehen, die in Verschiebungsrichtung 5' von den Ringkörpern 35, 37 abragen. Soll ein Testglaswechsel durchgeführt (d.h. das Monitorglas 26' des Testglashalters 8 um einen Winkel 33 gedreht) werden, so wird der Testglashalter 8 mit Hilfe des Drehtellers 2 in einer solchen Weise gegenüber der Hub-/Drehvorrichtung 34 positioniert, dass der Mittelpunkt 40 des Testglashalters 8 oberhalb des Mittelpunkts 39 der Ringkörper 35, 37 zu liegen kommt. Dann werden die beiden Ringkörper 35, 37 nach oben bewegt, bis die Stifte 38' des äußeren Ringkörpers 37 in Hohlräume 41 im Grundkörper 25 des Testglashalters 8 eindringen, während die Stifte 36' des inneren Ringkörpers 35 in den Innenraum 42 des Grundkörpers 41 aufgenommen werden. Die Längen der Stifte 36', 38' sind so bemessen, dass beim weiteren Vorschub der Ringkörper 35, 37 die Stifte 38' des äußeren Ringkörpers 37 den Deckel 28 des Testglashalters 8 anheben, während die Stifte 36' des inneren Ringkörpers 35 das Monitorglas 26' anheben, und zwar in einer solchen Weise, dass das Monitorglas 26' vom Grundkörper 25 abgehoben wird, während der Deckel 28 vom Monitorglas 26' abgehoben wird, so dass Monitorglas 26' bzw. Deckel 28 ohne gegenseitige Berührung - und ohne Berührung des Grundkörpers 25 - auf den Stiften 36' bzw. 38' ruhen. In dieser Lage wird das Monitorglas 26' durch eine Rotation des inneren Ringkörpers 35 um den Winkel 33 gedreht, während Grundkörper 25 und Deckel 28 in ihrer Position verweilen. Auf diese Weise kommt anstelle des ursprünglich unterhalb des Messfensters 29 gelegenen Monitorglasbereichs 31 nun anderer Bereich 31' des Monitorglases 26' unterhalb des Messfensters 29 zu liegen. Durch diese Drehung des Monitorglases 26' wird also gleichsam ein "Testglaswechsel" durchgeführt: Aufeinanderfolgende Drehungen des Monitorglases 26' gegenüber dem Deckel 28 ermöglichen es, unterschiedliche Bereiche 31, 31' des Monitorglases 26' in den Bereich des Messfensters 29 zu bewegen. Die Hub-/Drehvorrichtung 34 gestattet somit einen vollautomatischen Testglaswechsel innerhalb der geschlossenen Beschichtungskammer 1.

Die Größe und Lage des Messfensters 29 ist so bemessen, dass das Monitorglas 26' durch Drehung in mindestens sechs unterschiedliche Messpositionen, vorteilhafterweise acht (oder noch mehr) unterschiedliche Messpositionen bewegt werden kann. Im Ausführungsbeispiel der Figuren 3a und 3b hat das Monitorglas 26' einen Durchmesser von 125 mm, während das Messfenster 29 eine Dimension von 38 mm x 15 mm hat.

Eine Beschichtungssequenz läuft folgendermaßen ab: Zunächst werden die Substrate 7 und ein Testglashalter 8, der ein unbeschichtetes Monitorglas 26' enthält, durch die Substratschleuse 20 in die Beschichtungskammer 1 eingeschleust und in den dazu vorgesehenen Positionen 6 des Drehtellers 2 abgelegt. In einer ersten Beschichtungssequenz werden in der Sputtereinrichtung 12 die Substrate 7 und der unterhalb des Messfensters 29 liegende Bereich 31 des Monitorglases 26' einer ersten Beschichtung unterzogen; in der Messstation 13 wird während der Beschichtung insitu die sich ändernde Intensität von Transmission und/oder Reflexion gemessen und damit Dicke und Beschaffenheit, der im Bereich 31 des Monitorglases 26' abgelagerten Schicht optisch bestimmt. Nach diesem ersten Beschichtungsprozeß, der die Abscheidung von mindestens einer Schicht, in der Regel aber eine Vielzahl von Schichten umfasst, wird der Testglashalter 8 gegenüber der Hub-/Drehvorrichtung 34 positioniert und - wie oben beschrieben - durch Drehung des Monitorglases 26' ein Testglaswechsel durchgeführt, so dass nun anstelle des Bereiches 31 ein neuer Bereich 31' des Monitorglases 26' unterhalb des Messfensters 29 liegt. Anschließend wird eine zweite Beschichtungssequenz durchgeführt, mit einer zweiten insitu Messung. Dies wird bis zur letzten Beschichtungssequenz wiederholt. Falls die Zahl der gewünschten Beschichtungssequenzen größer ist als die Zahl der auf dem Monitorglas 26' platzierbaren Beschichtungsbereiche 31, 31', kann der Testglashalter 8 über die Substratschleuse 20 gegen einen neuen unbeschichteten Testglashalter ausgetauscht werden.

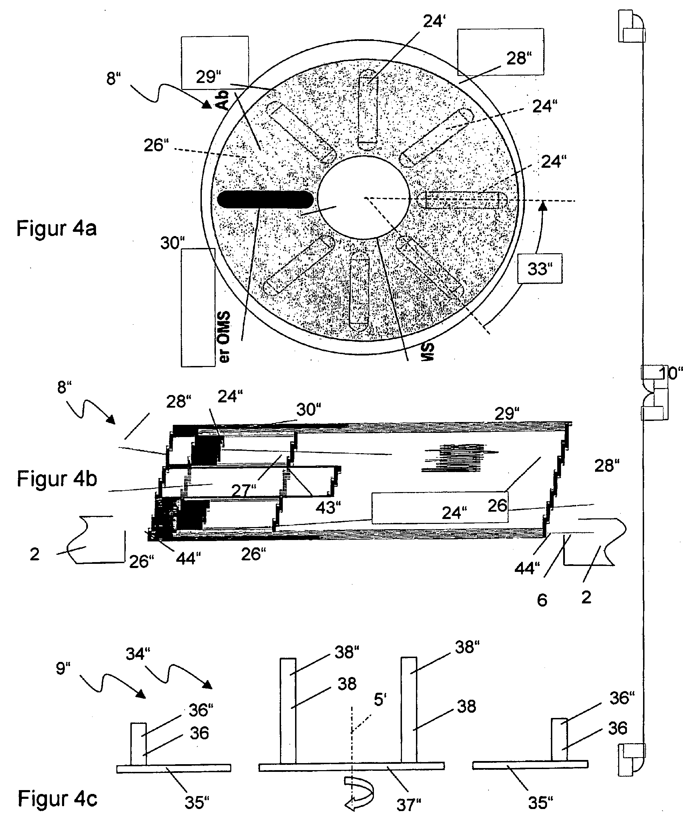

Figuren 4a - 4c zeigen eine weitere Ausgestaltung des erfindungsgemäßen Testglaswechselsystems. Dieses Testglaswechselsystem 10" umfasst einen Testglashalter 8", dessen Testglasplatte 26 durch eine Trägerplatte 26" gebildet ist, die Aussparungen für individuelle Messgläser 24', 24" aufweist. Im vorliegenden Ausführungsbeispiel sind die Messgläser 24', 24" durch längliche, endseitig abgerundete Glasplättchen 24" mit 40 mm Länge und 16 mm Breite gebildet, die symmetrisch auf der Trägerplatte 26" angeordnet sind; im Ausführungsbeispiel der Figur 4b kann die Trägerplatte 26" acht Messgläser 24" aufnehmen, die jeweils um einen Winkel 33" von 45° gegenüber dem benachbarten Messglas gedreht sind. Die Trägerplatte 26" weist mittig eine Aussparung 27" auf. Um eine gezielte Beschichtung eines ausgewählten Messglases 24' zu erreichen, ist die Trägerplatte 26" durch einen abnehmbaren kreisförmigen Deckel 28" abgedeckt. Wie aus der Aufsicht der Figur 4b ersichtlich ist, weist der Deckel 28" ein Messfenster 29" (zum Zugänglichmachen eines ausgewählten Messglases 24') und ein Referenzfenster 30" (zur Referenzmessung während der optischen Messung in der Messstation 13) auf. Wird der Testglashalter 8" auf dem Drehteller 2 durch die Beschichtungsstation 11 bewegt, so erfährt das unterhalb des Messfensters 29" liegende Messglas 24' eine Beschichtung, während die durch den Deckel 28" abgedeckten weiteren Messgläser 24" unbeschichtet bleiben. Die Dicke und Zusammensetzung dieser Beschichtung wird in der Messstation 13 ermittelt. In der Wechselstation 32 wird die Trägerplatte 26" des Testglashalters 8 um einen vorgegebenen Winkel 33" gedreht, um ein weiteres Messglas 24" unterhalb des Messfensters 29" im Deckel 28" zu platzieren. Diese Drehung der Trägerplatte 26" erfolgt mit Hilfe der als Hub-/Drehvorrichtung 34" ausgestalteten Drehvorrichtung 9", die am Boden 18 der Beschichtungskammer 1 befestigt ist und zwei konzentrisch angeordnete Ringkörper 35", 37" (siehe Figur 4c) umfasst. Der Mittelpunkt 39" der Ringkörper 35", 37" befindet sich direkt unterhalb des Großkreises 23 der auf dem Drehteller 2 gelagerten Substratscheiben 7. Der äußere Ringkörper 35" kann gesteuert um die Achse 5' gedreht werden, während die Ringkörper 35", 37" gemeinsam parallel zur Achse 5' verschoben werden können. Jeder der Ringkörper 35", 37" ist mit Hubelementen 36, 38 in Form eines nach oben abragenden ringförmigen Steges 36", 38" versehen. Bei einem Testglaswechsel werden die beiden Ringkörper 35", 37" nach oben bewegt, wobei der Steg 38" des inneren Ringkörpers 37" auf einen nach unten abragenden Rohrabschnitt 43" des Deckels 28" trifft und den Deckel 28" nach oben drückt, während der Steg 36" des äußeren Ringkörpers 35" auf den unteren Rand 44" die Trägerplatte 26" trifft und die Trägerplatte 26" anhebt. Die Längen der Stege 36", 38" sind so bemessen, dass beim gemeinsamen Vorschub der Ringkörper 35", 37" die Trägerplatte 26" vom Drehteller 2 abgehoben wird, während der Deckel 28" von der Trägerplatte 26" abgehoben wird, so dass Trägerplatte 26" und Deckel 28" ohne gegenseitige Berührung - und ohne Berührung des Drehtellers 2 - auf den Stegen 36", 38" ruhen. In dieser Lage wird die Trägerplatte 26" durch eine Rotation des äußeren Ringkörpers 35" um den Winkel 33" gedreht, während der auf dem Ringkörper 38" gehaltene Deckel 28" in seiner Position verweilt, so dass anstelle des ursprünglich unterhalb des Messfensters 29" gelegenen Testglases 24' nun ein anderes Testglas 24" unterhalb des Messfensters 29" zu liegen kommt. Durch aufeinanderfolgende Drehungen der Trägerplatte 26" gegenüber dem Deckel 28" können also unterschiedliche Testgläser 24', 24" in den Bereich des Messfensters 29" bewegt werden. Die Hub-/Drehvorrichtung 34" gestattet also einen vollautomatischen Testglaswechsel innerhalb der geschlossenen Beschichtungskammer 1.

## Patentansprüche

1. Testglaswechselsystem (10, 10") zur selektiven Beschichtung und optischen Messung eines Testglases (24, 24") in einer Beschichtungskammer (1) einer Vakuum-Beschichtungsanlage (3), in der ein beweglicher Drehteller (2) für die Führung mindestens eines Substrats (7) auf einer Bahn durch einen Strom eines Beschichtungsmaterials angeordnet ist,
- wobei das Testglaswechselsystem (10, 10") einen Testglashalter (8, 8") aufweist, der eine Testglasplatte (26) für die Aufnahme des Testglases (24, 24") und einen Deckel (28, 28") zur selektiven Abdeckung der Testglasplatte (26) umfasst,
- und wobei das Testglaswechselsystem (10) eine Drehvorrichtung (9) für die Drehung der Testglasplatte (26) um eine näherungsweise parallel zur Drehachse (5) des Drehtellers (2) ausgerichtete Achse (5') aufweist,
**dadurch gekennzeichnet, dass** der Testglashalter (8, 8") als Einheit auf dem Drehteller (2) positionierbar und aus der Beschichtungskammer (1) entnehmbar ist.

2. Testglaswechselsystem (10) nach Anspruch 1, **dadurch gekennzeichnet, dass** die Testglasplatte (26) durch ein kreisscheibenförmiges Monitorglas (26') gebildet ist.

3. Testglaswechselsystem (10) nach Anspruch 2, **dadurch gekennzeichnet, dass** das Monitorglas (26') eine zentrale Aussparung (27) aufweist.

4. Testglaswechselsystem (10") nach Anspruch 1, **dadurch gekennzeichnet, dass** die Testglasplatte (26) als Trägerplatte (26") zur Aufnahme einer Vielzahl von Testgläsern (24") ausgestaltet ist.

5. Testglaswechselsystem (10, 10") nach einem der vorangehenden Ansprüche, **dadurch gekennzeichnet, dass** die Testglas-Drehvorrichtung (9) als Hub-/Drehvorrichtung (34) ausgestaltet ist, mit deren Hilfe
- die Testglasplatte (26) in Achsrichtung (5') gegenüber dem Drehteller (2) verschiebbar ist,
- der Deckel (28, 28") in Achsrichtung (5') gegenüber der Testglasplatte (26) verschiebbar ist, und
- die Testglasplatte (26) um die Achsrichtung (5') drehbar ist.

6. Testglaswechselsystem (10, 10") nach Anspruch 5, **dadurch gekennzeichnet, dass** die Hub-/Drehvorrichtung (23) einen ersten Ringkörper (37, 37") zum Anheben des Deckels (28, 28") und einen zweiten Ringkörper (35, 35") zum Anheben und Drehen der Testglasplatte (26) aufweist.

7. Testglaswechselsystem (10, 10") nach Anspruch 5 oder 6, **dadurch gekennzeichnet, dass** die Hub-/Drehvorrichtung (34) ortsfest in der Bearbeitungskammer (1) angeordnet ist.

8. Testglaswechselsystem (10, 10") nach Anspruch 5 oder 6, **dadurch gekennzeichnet, dass** die Hub-/Drehvorrichtung (34) auf dem Drehteller (2) angeordnet ist.

9. Testglaswechselsystem (10, 10') nach einem der vorhergehenden Ansprüche, **dadurch gekennzeichnet, dass** eine Substratschleuse (20) zur Bestückung des Drehtellers (2) mit Substraten vorgesehen ist.

## Claims

1. Test glass changing system (10, 10") for selectively coating and optically measuring a test glass (24, 24") in a coating chamber (1) of a vacuum coating installation (3), in which a moveable rotary disk (2) is arranged for guiding at least one substrate (7) on a path through a coating material flow,
- wherein the test glass changing system (10, 10") has a test glass holder (8, 8"), which comprises a test glass plate (26) for holding the test glass (24, 24") and a cover (28, 28") for selectively covering the test glass plate (26),
- and wherein the test glass changing system (10) has a rotation device (9) for rotating the test glass plate (26) around an axis (5'), which is aligned approximately parallel to the rotational axis (5) of the rotary disk (2), **characterized in that** the test glass holder (8, 8") can be positioned on the rotary disk (2) as a unit and can be removed from the coating chamber (1).

2. Test glass changing system (10) according to Claim 1, **characterized in that** the test glass plate (26) is formed by a circular-disk-shaped monitor glass (26').

3. Test glass changing system (10) according to Claim 2, **characterized in that** the monitor glass (26') has a central cutout (27).

4. Test glass changing system (10") according to Claim 1, **characterized in that** the test glass plate (26) is embodied as a support plate (26") for holding a multiplicity of test glasses (24").

5. Test glass changing system (10, 10") according to one of the preceding claims, **characterized in that** the test glass rotation device (9) is embodied as a lift/rotation device (34), with the aid of which
- the test glass plate (26) can be displaced with respect to the rotary disk (2) in the axial direction (5'),
- the cover (28, 28") can be displaced with respect to the test glass plate (26) in the axial direction (5'), and
- the test glass plate (26) can be rotated around the axial direction (5').

6. Test glass changing system (10, 10") according to Claim 5, **characterized in that** the lift/rotation device (34) has a first annular body (37, 37") for lifting the cover (28, 28") and a second annular body (35, 35") for lifting and rotating the test glass plate (26).

7. Test glass changing system (10, 10") according to Claim 5 or 6, **characterized in that** the lift/rotation device (34) is arranged in the processing chamber (1) in a stationary fashion.

8. Test glass changing system (10, 10") according to Claim 5 or 6, **characterized in that** the lift/rotation device (34) is arranged on the rotary disk (2).

9. Test glass changing system (10, 10") according to one of the preceding claims, **characterized in that** provision is made of a substrate lock (20) for equipping the rotary disk (2) with substrates.

## Revendications

1. Système de remplacement de verre de test (10, 10'') pour l'enduction sélective et la mesure optique d'un verre de test (24, 24'') dans une chambre d'enduction (1) d'un équipement d'enduction sous vide (3), dans lequel un plateau tournant (2) mobile destiné au guidage d'au moins un substrat (7) est disposé sur une trajectoire à travers un courant d'un matériau d'enduction,
- le système de remplacement de verre de test (10, 10'') présentant un support de verre de test (8, 8'') qui comprend une plaque à verre de test (26) pour accueillir le verre de test (24, 24'') et un couvercle (28, 28") pour le recouvrement sélectif de la plaque à verre de test (26),
- et le système de remplacement de verre de test (10) présentant un dispositif de rotation (9) pour la rotation de la plaque à verre de test (26) autour d'un axe (5') orienté approximativement en parallèle avec l'axe de rotation (5) du plateau tournant (2), **caractérisé en ce que** le support de verre de test (8, 8") peut être positionné sur le plateau tournant (2) et peut être retiré de la chambre d'enduction (1) sous la forme d'une unité.

2. Système de remplacement de verre de test (10) selon la revendication 1, **caractérisé en ce que** la plaque à verre de test (26) est formée par un verre témoin (26') en forme de disque circulaire.

3. Système de remplacement de verre de test (10) selon la revendication 2, **caractérisé en ce que** le verre témoin (26') présente un évidement central (27).

4. Système de remplacement de verre de test (10") selon la revendication 1, **caractérisé en ce que** la plaque à verre de test (26) est configurée sous la forme d'une plaque porteuse (26") pour accueillir une pluralité de verres de test (24'').

5. Système de remplacement de verre de test (10, 10") selon l'une des revendications précédentes, **caractérisé en ce que** le dispositif de rotation du verre de test (9) est configuré sous la forme d'un dispositif de levage/rotation (34) à l'aide duquel
- la plaque à verre de test (26) peut coulisser dans le sens de l'axe (5') par rapport au plateau tournant (2),
- le couvercle (28, 28'') peut coulisser dans le sens de l'axe (5') par rapport à la plaque à verre de test (26), et
- la plaque à verre de test (26) peut tourner autour du sens de l'axe (5').

6. Système de remplacement de verre de test (10, 10'') selon la revendication 5, **caractérisé en ce que** le dispositif de levage/rotation (34) présente un premier corps annulaire (37, 37") pour soulever le couvercle (28, 28'') et un deuxième corps annulaire (35, 35'') pour soulever et faire tourner la plaque à verre de test (26).

7. Système de remplacement de verre de test (10, 10'') selon la revendication 5 ou 6, **caractérisé en ce que** le dispositif de levage/rotation (34) est monté en position fixe dans le chambre de traitement (1).

8. Système de remplacement de verre de test (10, 10'') selon la revendication 5 ou 6, **caractérisé en ce que** le dispositif de levage/rotation (34) est disposé sur le plateau tournant (2).

9. Système de remplacement de verre de test (10, 10'') selon l'une des revendications précédentes, **caractérisé en ce qu'**un sas à substrat (20) est prévu pour garnir le plateau tournant (2) de substrats.
